# EUROPÄISCHE PATENTSCHRIFT

(11) **EP 0 660 642 B1**
(45) Veröffentlichungstag und Bekanntmachung des Hinweises auf die Patenterteilung: **12.06.1996**
(21) Anmeldenummer: 94120230.1
(22) Anmeldetag: 20.12.1994
(51) Int. Cl.: H04R 25/02, H05K 9/00

(54) **Am Kopf tragbares Hörgerät**
Hearing aid to be worn on the head
Prothèse auditive à porter à la tête

(30) Priorität: 21.12.1993 DE 4343703
(43) Veröffentlichungstag der Anmeldung: 28.06.1995
(73) Patentinhaber: Siemens Audiologische Technik GmbH, D-91058 Erlangen (DE)
(72) Erfinder: Meyer, Wolfram, Dipl.-Ing. (FH), D-91096 Möhrendorf (DE)
(74) Vertreter: Fuchs, Franz-Josef, Dr.-Ing.

(56) Entgegenhaltungen:
- EP-A- 0 352 954
- DE-A- 3 502 178
- DE-U- 8 713 089
- US-A- 4 430 520
- US-A- 4 956 868
- US-A- 4 993 072

## Beschreibung

Die Erfindung betrifft ein am Kopf tragbares Hörgerät mit einem Gehäuse, in dem eine Verstärkerschaltung angeordnet ist, die wenigstens ein Mikrofon, einen Hörer und eine Batterie umfaßt, wobei wenigstens eine als elektrisch leitende Abschirmung der Verstärkerschaltung gegen hochfrequente elektromagnetische Wellen ausgebildete Schutzeinrichtung vorgesehen ist.

Bei einem aus der CH 664 057 A5 bekannten Hörgerät dieser Art ist zum Schutz der Schallwandler, d.h. um das Mikrofon gegen den vom Hörer abgestrahlten Luftschall abzuschirmen, eine elektromagnetische Abschirmung vorgesehen, die aus den Aufnahmeteil mindestens eines der Schallwandler einschließenden metallischen Halbschalen oder einer geeigneten Beschichtung der Außenseite des Aufnahmeteils gebildet wird.

Aus dem DE 87 13 089 U1 ist ein Hörgerät mit einer Hörspule zur Aufnahme von Induktionssignalen eines Telefons bekannt. Damit bei diesem Hörgerät der Hörer von den Magnetfeldern der Hörspule ausreichend abgeschirmt ist, wird zwischen Hörspule und Hörer ein Abschirmblech z.B. aus Mu-Metall angeordnet.

Hörgeräte der eingangs genannten Art können mit dem hörgeschädigten Träger des Hörgerätes in die Nähe starker Sender gelangen, wie z.B. Autotelefon, mobile Funkgeräte oder Mikrowellenbestrahlungsgeräte. In der Nähe eines derartigen Senders haben die abgestrahlten elektromagnetischen Wellen oft eine sehr hohe Feldstärke. Dadurch kann die Verstärkerschaltung im Hörgerät störend beeinflußt werden.

Der Erfindung liegt die Aufgabe zugrunde, bei einem Hörgerät der eingangs genannten Art die störende Beeinflussung der Verstärkerschaltung des Hörgerätes durch hohe Feldstärken von nahen Sendern mindestens weitgehend zu unterdrücken.

Diese Aufgabe wird durch die im Patentanspruch 1 angegebenen Merkmale gelöst. Erfindungsgemäß weist das Hörgerätegehäuse wenigstens eine Schutzeinrichtung auf, die als elektrisch leitende Abschirmung der Verstärkerschaltung gegen hochfrequente elektromagnetische Wellen ausgebildet ist, derart, daß bei Auftreffen von elektromagnetischen Wellen auf dieser Schutzeinrichtung Wirbelströme entstehen. Dadurch wird die Feldstärke der elektromagnetischen Wellen an der von dem Sender abgewandten Seite der Schutzeinrichtung mindestens vermindert. Die Wirkung dieser Schutzeinrichtung als elektrisch leitende Abschirmung der Verstärkerschaltung wird dadurch verbessert, daß die Schutzeinrichtung wenigstens eine leitende Verbindung zu einem elektrischen Anschluß der Verstärkerschaltung aufweist. Dabei kann diese leitende Verbindung z.B. über einen Kondensator hergestellt werden, der für Hochfrequenz einen ausreichend niedrigen Blindwiderstand bildet. Anstelle des Kondensators kann auch eine galvanische Verbindung vorgesehen sein. In jedem Fall wird eine besonders wirksame Abschirmung der Verstärkerschaltung gegen hochfrequente elektromagnetische Wellen erreicht.

Weitere Vorteile und Einzelheiten der Erfindung ergeben sich aus der nachfolgenden Beschreibung von Ausführungsbeispielen anhand der Zeichnungen und in Verbindung mit den Ansprüchen.

Es zeigen:
Figur 1 ein In-dem-Ohr-Hörgerät,
Figur 2 einen Ausschnitt II des In-dem-Ohr-Hörgerätes gemäß Figur 1,
Figur 3 einen Teilschnitt durch die Faceplate des In-dem-Ohr-Hörgerätes gemäß Figur 1,
Figur 4 ein Hinter-dem-Ohr-Hörgerät und
Figur 5 einen Teilschnitt durch das Gehäuse des Hinter-dem-Ohr-Hörgerätes gemäß Figur 4.

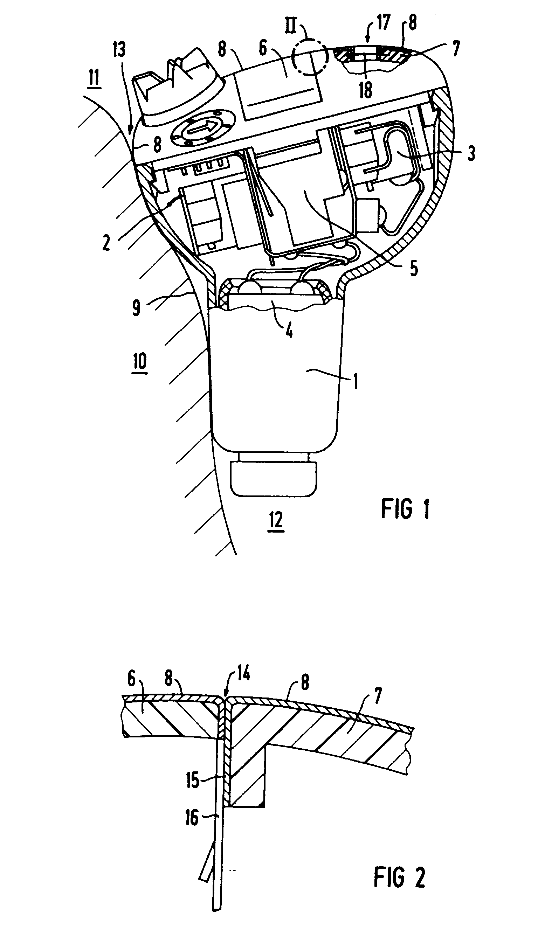

In Figur 1 ist ein am Kopf - im Gehörgang - tragbares Hörgerät mit einem Gehäuse 1 dargestellt. In dem Gehäuse 1 ist eine Verstärkerschaltung 2 mit verschiedenen elektronischen Bauteilen sowie z.B. einem Mikrofon 3, einem Hörer 4 und einer Batterie angeordnet, die in ein Batteriefach 5 einlegbar ist. Die Batterie kann über eine ausklappbare Batterielade 6 einer Faceplate 7 ausgewechselt werden. Die Faceplate 7 weist an der Oberfläche eine als elektrisch leitende Abschirmung der Verstärkerschaltung 2 gegen hochfrequente elektromagnetische Wellen ausgebildete Schutzeinrichtung 8 auf. Die Schutzeinrichtung 8 kann als metallisierte Oberfläche der Faceplate 7 ausgebildet sein. Es ist aber auch möglich, die Schutzeinrichtung 8 durch Leitlack (elektrisch leitender Lack), der auch als Gitterdruck auf die Oberfläche der Faceplate 7 aufgetragen sein kann, oder als Folie, die z.B. auf die Faceplate bzw. das Hörgerätegehäuse aufklebbar ist, herzustellen. Die Schutzeinrichtung 8 kann andererseits auch an der Innenseite der Faceplate 7 ober am Hörgerätegehäuse 1 insgesamt angeordnet sein.

Das in Figur 1 gezeichnete In-dem-Ohr-Hörgerät sitzt im äußeren Gehörgang 12 des Kopfes 10 des Hörbehinderten und liegt dabei mit seinem Gehäuse 1 möglichst dicht an der Wand 9 des Gehörganges an, der im Bereich des Ohres in eine Ohrmulde 11 übergeht. Die Faceplate 7 bildet einen äußeren Abschluß des Hörgerätegehäuses 1. Die Schutzeinrichtung 8 weist wenigstens eine elektrisch leitende Kontaktstelle 13 auf, die beim Tragen des Hörgerätes mit dem Kopf 10 des Hörgeräteträgers elektrisch leitend in Verbindung steht. Beim Tragen des Hörgerätes wird der an die Faceplate 7 anschließende Gehäuseteil des Gehäuses 1 von dem Kopf 10 umschlossen. Durch die elektrisch leitende Verbindung der Schutzeinrichtung 8 an der Faceplate 7 über die Kontaktstelle 13 mit dem Kopf 10 wird nach der Erfindung der Kopf 10 des Hörgeräteträgers in die Abschirmung der Verstärkerschaltung 2 gegen hochfrequente elektromagnetische Wellen mit einbezogen. Der Kopf 10 und die Schutzeinrichtung 8 bilden über die Kontaktstelle 13 eine elektrisch leitend verbundene Abschirmung der Verstärkerschaltung 2.

In Figur 2 ist ein Ausschnitt der Faceplate 7 an der Übergangsstelle zur Batterielade 6 dargestellt. Die Schutzeinrichtung 8 ist sowohl auf der Batterielade 6 als auch auf der Faceplate 7 angeordnet. Beide Teile der Schutzeinrichtung 8 liegen bei geschlossener Batterielade 6 längs eines Anschlages 14 elektrisch leitend aneinander. Die Schutzeinrichtung 8 an der Faceplate 7 weist eine wenigstens für Hochfrequenz leitende Verbindung 15 zu einem elektrischen Anschluß der Verstärkerschaltung 2 auf. Dieser elektrische Anschluß der Verstärkerschaltung 2 kann dabei in vorteilhafter Ausführung ein Kontakt 16 sein, der z.B. als Batteriekontaktfeder gemäß Figur 2 ausgebildet ist. Durch die leitende Verbindung 15 wird die Abschirmwirkung der Schutzeinrichtung 8 zusätzlich erhöht, wobei in der leitenden Verbindung zum Verstärker elektrische Mittel (Kondensator) vorgesehen sind, die einen elektrischen Schutzwiderstand für die Hochfrequenz bilden.

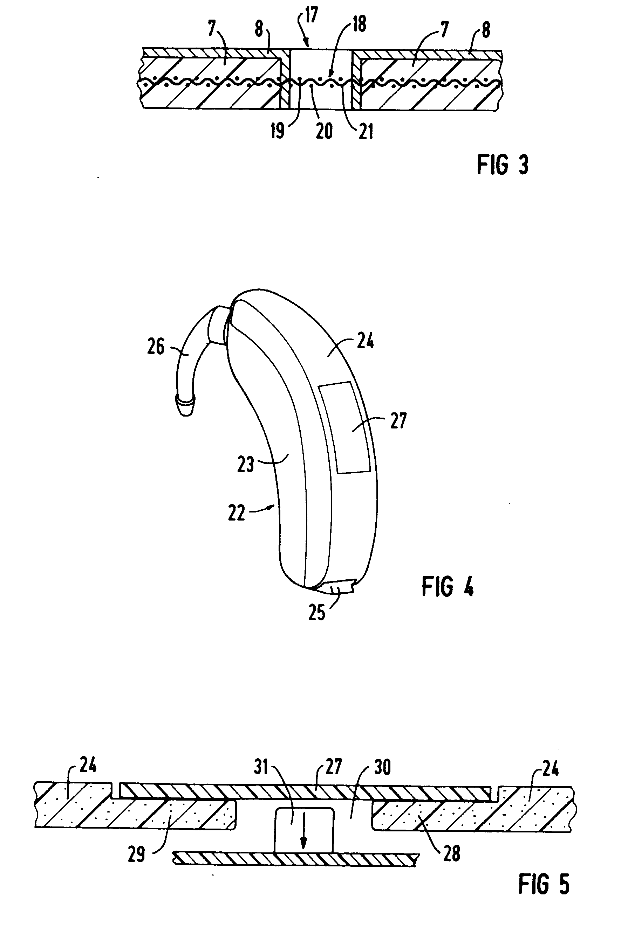

Das in Figur 1 dargestellte Hörgerät weist in der Faceplate 7 eine Schalleintrittsöffnung 17 zum Mikrofon 3 auf. Diese Öffnung 17 ist nach der Erfindung ebenfalls mit einer elektrisch leitenden Abschirmung gegen hochfrequente elektromagnetische Wellen ausgestattet. In Figur 3 ist ein Abschnitt der Faceplate 7 im Bereich der Schalleintrittsöffnung 17 im Schnitt dargestellt. Die Abschirmung ist aus einer elektrisch leitenden Gaze 18 (elektrisch leitendes und schalldurchlässiges Gewebe) mit Querfasern 19, 20 und Längsfasern 21 gebildet. Dieses Gewebe 18 ist eine Einlage, die elektrisch leitend mit der als Oberflächenbeschichtung der Faceplate 7 ausgebildeten Schutzvorrichtung 8 verbunden sein kann.

Nach einer vorteilhaften Ausführung ist es möglich, das in Figur 3 dargestellte Gewebe 18 innerhalb wenigstens eines Teils des Hörgerätegehäuses, z.B. der Faceplate 7, bei der Herstellung des Gehäuses einzulagern. Die als elektrisch leitende Abschirmung des Verstärkers 2 gegen hochfrequente elektromagnetische Wellen ausgebildete Schutzeinrichtung kann sonach in Form einer elektrisch leitenden Einlage bereits bei der Herstellung des Gehäuses 1, z.B. in der Faceplate 7, vorgesehen werden.

In Figur 4 ist ein am Kopf tragbares Hörgerät dargestellt, das hinter dem Ohr oder in Verbindung mit einer Hörbrille zu tragen ist. Dieses Hinter-dem-Ohr-Hörgerät weist ein Gehäuse 22 mit einer unteren Gehäuseschale 23 und einer oberen Gehäuseschale 24 auf. Beide Gehäuseschalen 23, 24 sind mit einer nicht dargestellten Schutzeinrichtung gegen hochfrequente elektromagnetische Wellen ausgestattet, wie zu dem IdO-Hörgerät gemäß Figur 1 beschrieben ist. Die Schutzeinrichtung erstreckt sich auch über eine Batterielade 25 am unteren Teil des Gehäuses 22. Am oberen Teil des Gehäuses 22 tritt ein Schlauch 26 zur Überleitung des Schalls vom Hörer des Hörgerätes zum Ohr des Hörgeräteträgers aus. Die Schallaustrittsöffnung (nicht dargestellt) am Gehäuse 22 kann ebenfalls mit einer Abschirmung versehen sein, wie zu der Schalleintrittsöffnung 17, insbesondere gemaß Figur 3, beschrieben ist.

In Ausbildung der Erfindung weist das Gehäuse 22 in Figur 4 einen geschlossenen Bereich 27 auf, der wenigstens teilweise flexibel ausgebildet ist. Dazu ist gemäß Figur 5 ein Gehäuseausschnitt im Querschnitt dargestellt. Der flexible Bereich 27 ist elektrisch leitend ausgebildet und ist elektrisch leitend an vorstehenden Zungen 28, 29 der Gehäuseschale 24 des Gehäuses 22 befestigt. Die Gehäuseschale 24 kann z.B. auch durch Beimengung von elektrisch leitendem Pulver, z.B. Graphit, insgesamt elektrisch leitend und dadurch als Schutzeinrichtung gegen hochfrequente elektromagnetische Strahlung ausgebildet sein. Unter dem flexiblen Bereich 27 ist in einer abgedeckten Öffnung 30 der Gehäuseschale 24 ein Betätigungselement 31 für die Verstärkerschaltung 2 angeordnet. Nach dieser Ausbildung der Schutzvorrichtung können keine hochfrequenten elektromagnetischen Wellen z.B. über die Öffnung 30 für ein Betätigungselement 31 und/oder über das Betätigungselement 31 zu dem Verstärker gelangen.

## Patentansprüche

1. Am Kopf tragbares Hörgerät mit einem Gehäuse (1), in dem eine Verstärkerschaltung (2) angeordnet ist, die wenigstens ein Mikrofon (3), einen Hörer (4) und eine Batterie umfaßt, wobei wenigstens eine als elektrisch leitende Abschirmung der Verstärkerschaltung (2) gegen hochfrequente elektromagnetische Wellen ausgebildete Schutzeinrichtung (8) vorgesehen ist,
**dadurch gekennzeichnet,**
daß die Schutzeinrichtung (8) für Hochfrequenz eine leitende Verbindung (15) zu einem elektrischen Anschluß der Verstärkerschaltung (2) aufweist und wobei in der leitenden Verbindung elektrische Mittel vorgesehen sind, die einen elektrischen Widerstand für die Hochfrequenz bilden.

2. Hörgerät nach Anspruch 1,
**dadurch gekennzeichnet,**
daß die Schutzeinrichtung (8) wenigstens eine elektrisch leitende Kontaktstelle (13) aufweist, die beim Tragen des Hörgerätes mit dem Kopf (10) des Hörgeräteträgers elektrisch leitend in Verbindung steht.

3. Hörgerät nach Anspruch 1,
**dadurch gekennzeichnet,**
daß der elektrische Anschluß der Verstärkerschaltung (2) als ein Kontakt (16) zur Batterie des Hörgerätes ausgebildet ist.

4. Hörgerät nach Anspruch 1,
**dadurch gekennzeichnet,**
daß die Faceplate (7) eines In-dem-Ohr-Hörgerätes als Schutzeinrichtung (8) ausgebildet ist.

5. Hörgerät nach einem der Ansprüche 1 bis 4,
**dadurch gekennzeichnet,**
daß das mit einer Abschirmung versehene und im Bereich eines Schaltmittels geschlossen ausgebildete Gehäuse (1) einen flexibel und elektrisch leitenden Bereich (27) zur Betätigung eines darunter angeordneten Betätigungselementes (31) der Verstärkerschaltung (2) aufweist.

## Claims

1. Hearing aid which can be worn on the head, having a housing (1) in which an amplifier circuit (2) is arranged, comprising at least a microphone (3), an earphone (4) and a battery, wherein at least one protective device (8) is provided, constructed as an electroconductive shield of the amplifier circuit (2) against high-frequency electromagnetic waves, characterized in that the protective device (8) for high frequency has a conductive connection (15) to an electrical terminal of the amplifier circuit (2) and wherein electrical means are provided in the conductive connection, which means form an electrical resistance for the high frequency.

2. Hearing aid according to claim 1, characterized in that the protective device (8) has at least one electroconductive point of contact (13) which is electroconductively connected to the head (10) of the person wearing the hearing aid when the hearing aid is worn.

3. Hearing aid according to claim 1, characterized in that the electrical terminal of the amplifier circuit (2) is constructed as a contact (16) to the battery of the hearing aid.

4. Hearing aid according to claim 1, characterized in that the face-plate (7) of an in-the-ear hearing aid is constructed as a protective device (8).

5. Hearing aid according to one of claims 1 to 4, characterized in that the housing (1) provided with a shield and constructed to be closed in the region of switching means has a flexible and electroconductive area (27) for actuating an actuating element (31) of the amplifier circuit (2), the element (31) being arranged under the area (27).

## Revendications

1. Prothèse auditive pouvant être portée à la tête et comportant un boîtier (1) dans lequel est disposé un circuit amplificateur (2) comportant au moins un microphone (3), un écouteur (4) et une pile, et dans lequel il est prévu au moins un dispositif de protection (8) sous la forme d'un blindage conducteur de l'électricité, du circuit amplificateur (2) vis-à-vis d'ondes électromagnétiques de haute fréquence,
caractérisée par le fait que
le dispositif de protection (8) comporte, pour les hautes fréquences, une liaison conductrice (15) avec une borne électrique du circuit amplificateur (2), des moyens électriques, qui forment une résistance électrique pour les hautes fréquences, étant prévus dans la liaison conductrice.

2. Prothèse auditive selon la revendication 1,
caractérisée en ce que
le dispositif de protection (8) comporte au moins un point de contact (13) conducteur de l'électricité, qui, lorsque la prothèse auditive est portée, établit une liaison conductrice de l'électricité avec la tête (10) du porteur de la prothèse auditive.

3. Prothèse auditive selon la revendication 1,
caractérisée en ce que
la borne électrique du circuit amplificateur (2) est sous la forme d'un contact (16) avec la pile de la prothèse auditive.

4. Prothèse auditive selon la revendication 1,
caractérisée par le fait que
la plaque avant (7) d'une prothèse auditive intraauriculaire est sous la forme du dispositif de protection (8).

5. Prothèse auditive suivant l'une des revendications 1 à 4,
caractérisée par le fait que
le boîtier (1), qui est muni d'un blindage et qui est fermé dans la zone d'un moyen de commutation, comporte une zone (27) flexible et conductrice de l'électricité destinée à actionner un élément d'actionnement (31), disposé au-dessous de cette zone, du circuit amplificateur (2).
